Europäisches Patentamt

European Patent Office

Office européen des brevets

(19)

(11) EP 0 706 055 B1

(12) EUROPÄISCHE PATENTSCHRIFT

(45) Veröffentlichungstag und Bekanntmachung des Hinweises auf die Patenterteilung:
05.12.2001 Patentblatt 2001/49

(51) Int Cl.$^7$: G01R 27/28, G01R 35/00

(21) Anmeldenummer: 95115297.4

(22) Anmeldetag: 28.09.1995

(54) **Verfahren zum Kalibrieren eines Netzwerk-Analysators nach dem 7-Term-Prinzip**

Method for calibrating a network analyzer according to the 7-term principle

Procédé d'étalonnage d'un analyseur de réseau selon le principe des 7 termes

(84) Benannte Vertragsstaaten:
DE ES FR GB IT

(30) Priorität: 05.10.1994 DE 4435559

(43) Veröffentlichungstag der Anmeldung:
10.04.1996 Patentblatt 1996/15

(73) Patentinhaber:
• Rohde & Schwarz GmbH & Co. KG
D-81671 München (DE)
• Rosenberger Hochfrequenztechnik GmbH & Co.
84526 Tittmoning (DE)

(72) Erfinder:
• Heuermann, Holger, Dipl.-Ing.
D-84529 Tittmoning (DE)
• Schiek, Burkhard, Prof.Dr.Ing.
D-44801 Bochum (DE)

(74) Vertreter: Körfer, Thomas, Dipl.-Phys. et al
Mitscherlich & Partner,
Patent- und Rechtsanwälte,
Sonnenstrasse 33
80331 München (DE)

(56) Entgegenhaltungen:
EP-A- 0 568 889          DE-A- 3 912 795
GB-A- 2 273 364

• 22ND EUROPEAN MICROWAVE CONFERENCE 92, Bd. 2, 24. - 27.August 1992 ESPOO,FI, Seiten 907-912, XP 000337853 HEUERMANN 'a generalization of the txx network analyzer seil-calibration procedure'
• IEEE TRANS. ON MICROWAVE THEORY AND TECHN., Bd. 39, Nr. 4, April 1991 NEW YORK,US, Seiten 724-731, XP 000179068 EUL 'a generalized theory'

## Beschreibung

Die Erfindung geht aus von einem Verfahren laut Oberbegriff des Patentanspruches 1.

Ein Verfahren dieser Art ist bekannt (EP-A 0 568 889). Dieses sogenannte 7-Term-Kalibrierverfahren besitzt den Vorteil, daß nur drei Kalibrierstandards benötigt werden. Voraussetzung ist jedoch, daß von der für die erste Kalibriermessung benutzten Leitung sowohl der Wellenwiderstand als auch die komplexe Ausbreitungskonstante bekannt sind. Wenn die Ausbreitungskonstante dieser Leitung nicht bekannt ist, muß noch eine vierte Kalibriermessung durchgeführt werden.

Es ist Aufgabe der Erfindung, ein Kalibrierverfahren nach dem 7-Term-Prinzip aufzuzeigen, das nur mit drei Kalibrierstandards durchführbar ist, obwohl für die erste Kalibriermessung eine elektrische Leitung benutzt wird, von der nur der Wellenwiderstand bekannt ist.

Diese Aufgabe wird jeweils ausgehend von einem Verfahren laut Oberbegriff der nebengeordneten Ansprüche 1, 2 und 3 durch die jeweils kennzeichnenden Merkmale gelöst. Eine vorteilhafte Weiterbildung ergibt sich aus dem Unteranspruch 4.

Das erfindungsgemäße Verfahren kann mit nur drei Kalibrierstandards ausgeführt werden, da von der für die erste Kalibriermessung benutzten elektrischen Leitung nur der Wellenwiderstand bekannt sein muß, während die elektrische Ausbreitungskonstante unbekannt und komplex sein darf, da diese anschließend aus sämtlichen Kalibriermessungen auf einfache Weise berechnet werden kann, wie dies bei sogenannten Selbstkalibrierverfahren an sich bekannt ist (deutsche Offenlegungsschrift 39 12 795). Durch die Anwendung dieses an sich bekannten Selbstkalibrierprinzips bei einem Verfahren der eingangs erwähnten Art kann auch der erste Kalibrierstandard sehr einfach und preiswert in planarer Streifenleitungstechnik aufgebaut werden. Ein solchere Kalibrierstandard ist damit besonders geeignet zum Kalibrieren eines Netzwerk-Analysators, mit dem anschließend an planaren Mikrowellenschaltungen sogenannte On-Wafer-Messungen durchgeführt werden sollen.

Bei dem sogenannten LZY-Verfahren nach Anspruch 1 wird für die zweite und dritte Kalibriermessung jeweils der gleiche Kalibrierstandard benutzt. Bei dem sogenannten LZN-Verfahren nach Anspruch 2 wird für die zweite Kalibriermessung ein Zweitor benutzt, das nur aus einer Serienimpedanz besteht, die Impedanz gegen Masse entfällt. Bei dem sogenannten LMS- bzw. LMO-Verfahren nach Anspruch 3 werden für die zweite und dritte Kalibriermessung an sich bekannte Eintor-Kalibrierstandards benutzt. Für die erste Kalibriermessung wird beispielsweise ein Wellensumpf M benutzt, dessen Impedanz dem Wellenwiderstand entspricht und der nacheinander an die beiden Meßtore angeschaltet wird (sogenannte Doppeleintor-Kalibrierung MM). Für die dritte Kalibriermessung wird wieder eine Doppeleintor-Kalibrierung mit einem Kurzschluß SS oder Leerlauf OO durchgeführt. Damit können kommerziell erhältliche Kalibriersubstrate für die zweite und dritte Kalibriermessung eingesetzt werden.

Gemäß der nachfolgenden Beschreibung im Zusammenhang mit Gleichung (16) wird bei der anschließenden Berechnung das Produkt von elektrischer Ausbreitungskonstante $\gamma$ und mechanischer Länge l der verwendeten Leitung berechnet, da für die Kalibrierung nach dem 7-Term-Verfahren dieses Produkt $\gamma\ell$ benötigt wird. Für die Kalibrierung kann also auch die mechanische Länge der Leitung unbekannt sein. Nachdem für die anschließende Objektmessung jedoch oftmals nur die komplexe Ausbreitungskonstante $\gamma$ von Interesse ist, beispielsweise für die Einstellung der Referenzebene, kann aus diesem berechneten Produkt $\gamma\ell$ bei Kenntnis der mechanischen Länge der verwendeten Leitung auf einfache Weise auch unmittelbar $\gamma$ ermittelt werden.

Das erfindungsgemäße Verfahren ist besonders geeignet für On-Wafer-Messungen, bei denen die beiden Meßtore in den Meßspitzen enden, die unmittelbar auf den Leiterbahnen des Halbleitersubstrats nicht zu eng nebeneinander aufgesetzt werden und daher noch nicht miteinander verkoppelt sind.

Die Erfindung wird im folgenden anhand schematischer Zeichnungen an Ausführungsbeispielen näher erläutert.

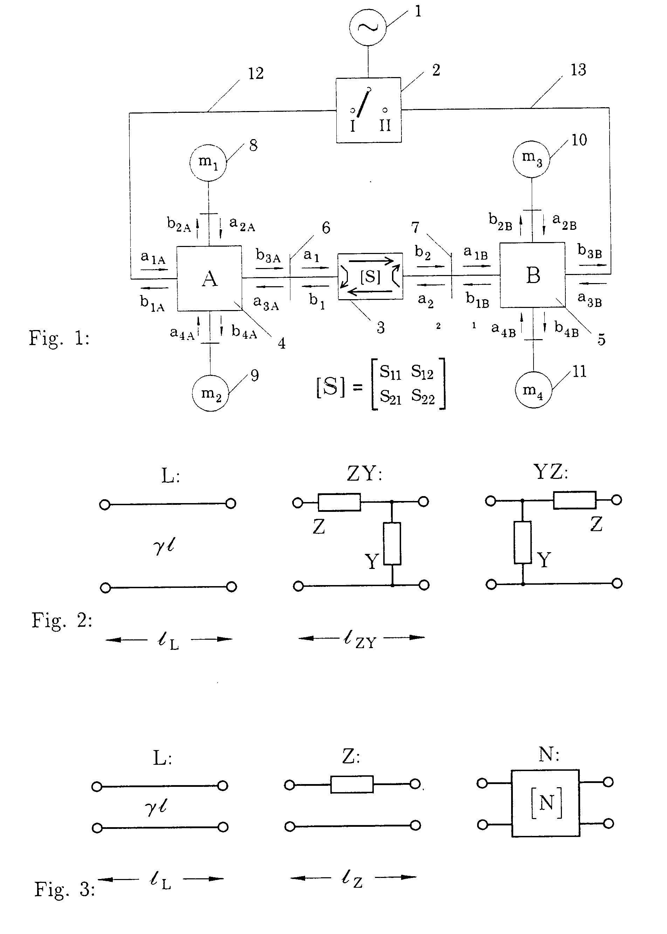

Fig. 1 zeigt ein stark vereinfachtes Prinzipschaltbild eines Netzwerkanalysators (NWA), bei dem über einen Umschalter 2 zwei Meßzweige 12 und 13 aus einem Hochfrequenzgenerator 1 gespeist sind. Diese Meßzweige münden in zwei Viertoren 4 und 5, von denen ein lineares Übertragungsverhalten und zusätzlich eine Entkopplung der Meßstellen 8 und 9 bzw. 10 und 11 verlangt wird. Im Falle vom Streuparametermessungen ist es vorteilhaft, wenn diese Viertore allseitige Anpassung und die Struktur einer Brücke aufweisen, so daß beispielsweise die Meßstelle 8 ein Maß für die hinlaufende Welle aus dem Zweig 12 und die Meßstelle 9 ein Maß für die vom Meßobjekt 3 zulaufende Welle bildet. Möchte man jedoch Impedanzparameter aufnehmen, so kann ein derartiges niederohmiges Testset ungünstig sein. Wie auch immer, sofern die Entkopplung der Meßstellen und ein lineares Übertragungsverhalten der Viertore 4 und 5 des Testsets gesichert sind, kann durch Einsatz eines Systemfehlerkorrekturverfahrens auf jede lineare Beschreibungsform von Netzwerken übergegangen werden.

Die Meßtore 6 und 7 bilden den Übergang zu dem Meßobjekt 3 und werden auch als Referenzebenen bezeichnet. Nach dem sogenannten Zweitor-Fehlermodell (7-Term Modell) werden hierbei die zwischen den Meßpunkten 8, 9, 10 und 11 und dem an den eigentlichen Meßtoren 6 und 7 angeschalteten Meßobjekt 3 auftretenden Störgrößen, die beispielsweise durch die zum Meßobjekt führenden Verbindungsleitungen, Fehlanpassungen und unerwünschte Verkopplungen verursacht werden, durch sogenannte Fehlernetzwerke berücksichtigt, die durch ein Kalibrierverfahren ermittelt und bei der eigentlichen Messung als Korrekturwerte berücksichtigt werden.

Bei der Kalibriermessung wird das Meßobjekt 3 durch Kalibrierstandards ersetzt und es werden dann wiederum pro Standard vier Meßwerte für jede Schalterstellung des Umschalters 2 erfaßt.

Zur Veranschaulichung der folgenden Zweitor-Selbstkalibrierverfahren LZY, LZN, LZZN und LMS ist es unabdingbar die Abbildungsgleichung der 7-Term-Verfahren kurz herzuleiten.

Grundlegende Herleitung für die 7-Term Verfahren

Im weiteren soll die mathematische Herleitung in allgemeiner Form basierend auf Fig. 1 erfolgen, so daß sowohl Ketten- als auch Transmissionsparameter einsetzbar wären. Behandelt werden die elektrischen Größen an den Meßstellen wie allgemeine Meßwerte, die entweder Ströme und Spannungen oder Wellengrößen repräsentieren können.

Die mathematische Formulierung des Zweitor-Fehlermodells wird in Ketten- bzw. Transmissionsparametern angesetzt:

$$\begin{pmatrix} m_1 \\ m_2 \end{pmatrix} = [\mathbf{A}]\,[\mathbf{N}]\,[\mathbf{B}]^{-1} \begin{pmatrix} m_3 \\ m_4 \end{pmatrix} \ . \tag{1}$$

Die Matrizen [**A**] und [**B**] sind Fehlermatrizen, die sich nach der sogenannten Viertor-Zweitor-Reduktion ergeben. Über diesen Matrizen werden die physikalischen Größen des Meßobjektes DUT, das durch die Matrix [**N**] beschrieben sei, zu den Meßstellen transformiert.

Für jede Schalterstellung des im Fig. 1 dargestellten NWA, der auch als Doppelreflektometer bezeichnet wird, erhält man eine sinnvolle Gleichung, die vereint die folgende Matrizengleichung ergibt.

$$\begin{pmatrix} m_1' & m_1'' \\ m_2' & m_2'' \end{pmatrix} = [\mathbf{A}][\mathbf{N}][\mathbf{B}]^{-1} \begin{pmatrix} m_3' & m_3'' \\ m_4' & m_4'' \end{pmatrix} \tag{2}$$

Durch die Multiplikation mit der Inversen der rechten Meßwertmatrix ergibt sich

$$[M] = [A][N][B]^{-1} \ , \tag{3}$$

mit der resultierenden Meßwertmatrix:

$$[\mathbf{M}] = \begin{pmatrix} m_1' & m_1'' \\ m_2' & m_2'' \end{pmatrix} \begin{pmatrix} m_3' & m_3'' \\ m_4' & m_4'' \end{pmatrix}^{-1} \ . \tag{4}$$

Das LZY-Verfahren

Für die drei Kalibrierobjekte der Fig. 2 erhält man in Referenz zur Gleichung (3) in Form von Kettenparametern:

$$L : [Ml] = [A]\,[Kl]\,[B]^{-1} \ , \tag{5}$$

$$ZY : [Mzy] = [A]\,[Kzy]\,[B]^{-1} \ , \tag{6}$$

$$YZ : [Myz] = [A]\,[Kyz]\,[B]^{-1} \ , \tag{7}$$

mit den jeweiligen Kettenmatrizen

$$[\mathbf{Kl}] \;=\; \begin{pmatrix} \cosh\left(\gamma\ell\right) & \sinh\left(\gamma\ell\right) \\ \sinh\left(\gamma\ell\right) & \cosh\left(\gamma\ell\right) \end{pmatrix} \quad, \tag{8}$$

$$[\mathbf{Kzy}] \;=\; \begin{pmatrix} 1+zy & z \\ y & 1 \end{pmatrix} \quad, \tag{9}$$

$$[\mathbf{Kyz}] \;=\; \begin{pmatrix} 1 & z \\ y & 1+zy \end{pmatrix} \quad. \tag{10}$$

Lediglich der Wert des Impedanzstandards $z$ soll innerhalb der Gleichungen (8)-(10) bekannt sein. Die sogenannte Selbstkalibrierung hat nunmehr die Aufgabe, die Größe der Admittanz $y$ und das Produkt der komplexen Ausbreitungs- konstanten $\gamma$ mit der mechanischen Länge $\ell$ hervorzubringen. Aus praktischen Gründen wird man die Wahl der Werte für den ZY-Standard so wählen, daß dieser von einer Seite auf 50 $\Omega$ angepaßt ist. Desweiteren wird man als YZ- Standard den gedrehten ZY-Standard verwenden.
Zunächst soll die Matrix $[\mathbf{B}]^{-1}$ in der Gleichung (6) mittels der Gleichung (7) eliminiert werden.

$$[Myz]\,[Mzy]^{-1} = [A]\,[Kyz]\,[Kzy]^{-1}\,[A]^{-1} \tag{11}$$

Mithin ist man zu einer linearen Abbildung der Parameter der Kalibrierobjekte und deren zugehörigen Meßwerten gelangt, die als Ähnlichkeitstransformation bezeichnet wird. Unter Ausnutzung der Spur-Äquivalenz kann man eine Berechnungsgleichung für die unbekannte Admittanz $y$ herleiten:

$$y = \pm \frac{\sqrt{\beta_1 - 2}}{z} \;, \tag{12}$$

mit der sich aus den Meßwerten ergebenen Größe $\beta_1$.

$$\beta_1 = \mathrm{spur}\,([Myz][Mzy]^{-1}) \tag{13}$$

Eliminiert man die Matrix $[\mathbf{B}]^{-1}$ der Gleichung (5) mittels der Gleichung (6), so gelangt man zur Gleichung (14).

$$[Ml]\,[Mzy]^{-1} = [A][Kl][Kzy]^{-1}[A]^{-1} \tag{14}$$

Aus der Spur-Äquivalenz folgt Gleichung (15).

$$\underbrace{\mathrm{spur}\left([\mathbf{Ml}]\,[\mathbf{Mzy}]^{-1}\right)}_{=\beta_2} = \underbrace{\frac{1}{2}(2+zy-z-y)}_{=\alpha_1}\mathrm{e}^{\gamma\ell} + \underbrace{\frac{1}{2}(2+zy+z+y)}_{=\alpha_2}\mathrm{e}^{-\gamma\ell} \tag{15}$$

Die Auswertung dieser Gleichung bringt das gesuchte Produkt $\gamma\ell$ hervor.

$$\gamma\ell = \ln\left(\frac{\beta_2}{2\alpha_1} \pm \sqrt{\left(\frac{\beta_2}{2\alpha_1}\right)^2 - \frac{\alpha_2}{\alpha_1}}\right) \tag{16}$$

Die Vorzeichenunsicherheit muß wie auch bei anderen Kalibrierverfahren über eine Vorabinformation der elektrischen Länge von ±90° gelöst werden.

Was dieses einfache Selbstkalibrierverfahren gegenüber dem zur Zeit verwendeten Kalibrierverfahren LRM auszeichnet, das sind folgende Eigenschaften:

- Bei dem LRM-Verfahren muß die Leitung komplett bekannt sein, hingegen muß beim LZY-Verfahren nur eine angepaßte Leitung eingesetzt werden.

- Die bekannte Bezugsimpedanz liegt bei dem LRM-Verfahren gegen Masse, hingegen liegt diese bei dem LZY-Verfahren planar in Serie, was einer präzisen Herstellbarkeit zugute kommt.

- Da sich der Z-Standard einfacher herstellen läßt als der M-Standard, ist dieser ZY-Standard auch bis zu höheren Frequenzen gut realisierbar.

- Die zwei Kalibrierstandards des LZY-Verfahrens benötigen weniger Platz als die Standards des LRM-Verfahrens, was insbesondere bei der Herstellung auf teueren Halbleitersubstraten sehr wichtig ist.

Somit ist es offensichtlich, daß für on-wafer-Messungen das LZY-Verfahren nicht nur eine gute Alternative zum LRM-Verfahren darstellt, sondern als nächster Schritt im Bereich der Selbstkalibrierverfahren für on-wafer-Messungen im übersprecherfreien Fall angesehen werden darf.

Das LZN-Verfahren

Die Kalibrierstandards des erfindungsgemäßen LZN-Verfahrens sind im Fig. 3 abgebildet. Die Kalibrierleitung muß wie üblich Anpassung aufweisen. Die Ausbreitungskonstante $\gamma$ muß jedoch nicht bekannt sein. Der Impedanzwert des Z-Standards stellt die Bezugsimpedanz dar. Von dem N-Standard wird lediglich Reflexionssymmetrie gefordert. Zunächst beschäftigen wir uns für die Berechnung der Ausbreitungskonstante lediglich mit den Standards L und Z. Diese beiden Standards ergeben in Referenz zur Gleichung (3) in Transmissionsparametern:

$$L : [Ml]=[A][Nl][B]^{-1} \, , \tag{17}$$

$$Z : [Mz]=[A][Nz] [B]^{-1} \, , \tag{18}$$

mit den Transmissionsparametermatrizen

$$[\mathbf{Nl}] \quad = \quad \begin{pmatrix} e^{\gamma\ell} & 0 \\ 0 & e^{-\gamma\ell} \end{pmatrix} \quad , \tag{19}$$

$$[\mathbf{Nz}] \quad = \quad \frac{1}{2} \begin{pmatrix} 2 - z & z \\ -z & 2 + z \end{pmatrix} \quad . \tag{20}$$

Die Länge $\ell$ ergibt sich aus der Differenzlänge zwischen der physikalischen Ausdehnung des L- und des Z-Standards (Bild 3).

$$\ell = \ell_L - \ell_Z \tag{21}$$

Eliminiert man wiederum die Matrix $[\mathbf{B}]^{-1}$ in den Gleichungen (17) und (18), so erhält man über die Spur-Äquivalenz erneut eine einfache Selbstkalibriergleichung zur Berechnung des Produktes von Ausbreitungskonstante und Differenzlänge $(\gamma\ell)$. Diese Gleichung (22) enthält neben den Meßwerten nur noch den auf den Bezugswiderstand normierten Impedanzwert $z$.

$$\gamma \ell = \ln \left( \alpha_1 \pm \sqrt{(\alpha_1)^2 - \alpha_2} \right) \qquad (22)$$

Gleichung (22) beinhaltet nachfolgende Abkürzungen:

$$\alpha_1 = \frac{\beta_1}{2 - z} , \qquad (23)$$

$$\alpha_2 = \frac{2 + z}{2 - z} , \qquad (24)$$

$$\beta_1 = \text{spur} ([Mz] (MI]^{-1}) . \qquad (25)$$

Man erkennt, daß eine Impedanz $z$ ungleich dem doppelten Wert der Bezugsimpedanz sein muß, ansonsten werden dieser Gleichungen singulär. Die Vorzeichenunsicherheit und die weiteren Bedingungen bezüglich des L-Standards verhalten sich wie bei dem LZY-Verfahren.

Widmen wir uns an dieser Stelle dem dritten Kalibrierstandard N, der die drei unbekannten Streuparametergrößen $Sn_{11}$, $Sn_{12}$ und $Sn_{21}$ aufweisen soll. Damit dieser reflexionssymmetrische Standard auch aus denen in der Praxis wichtigen Eintor-Standards bestehen kann, ist ein Übergang zu den sogenannten Pseudotransmissionsparametern notwendig.

Für diesen Übergang zerlegen wir die Meßwertmatrix der Gleichung (4) wie folgt.

$$[\mathbf{Mn}] = \underbrace{\frac{1}{m_3' m_4'' - m_3'' m_4'}}_{= \frac{1}{m_{nx}}} \underbrace{\begin{pmatrix} m_1' & m_1'' \\ m_2' & m_2'' \end{pmatrix} \begin{pmatrix} m_3' & \tilde{m}_3'' \\ m_4' & m_4'' \end{pmatrix}^T}_{=[\mathbf{Mn'}]} \qquad (26)$$

Dieser Schritt ist notwendig, da bei einem Doppeleintor-Kalibrierstandard $m_{nx}$ zu Null wird. Ordnen wir den physikalischen Parametern des N-Standards diese Meßwertdeterminante zu, so läßt sich für den dritten Standard die Gleichung (3) derartig formulieren:

$$[\mathbf{Mn'}] = [\mathbf{A}] \underbrace{m_{nx} [\mathbf{Nn}]}_{=[\mathbf{Nn'}]} [\mathbf{B}]^{-1} \quad . \qquad (27)$$

Die Größen des Netzwerks [$\mathbf{Nn'}$] stehen in folgendem Zusammenhang mit den Streuparametern.

$$[\mathbf{Nn'}] = \frac{1}{T} \begin{pmatrix} -r^2 + t\,T & r \\ -r & 1 \end{pmatrix} \qquad (28)$$

$$t = Sn_{12} \cdot m_{nx} \qquad (29)$$

$$T = Sn_{21} / m_{nx} \qquad (30)$$

$$r = Sn_{11} = Sn_{22} \qquad (31)$$

Verknüpft man die Gleichung (27) mit den Gleichungen (17) und (18), so gelang man über die Ähnlichkeitstransformation zu vier nichtlinearen Gleichungen, die man zur Ermittlung der drei gesuchten Parametern braucht und deren Struktur den Abkürzungen $\beta_i$ der Meßwertgleichungen zu entnehmen ist.

$$T^2\beta_4 = e^{\gamma\ell}(tT - r^2) + e^{\gamma\ell} \tag{32}$$

$$T\beta_4 = t \tag{33}$$

$$2T\beta_5 = \alpha_3(tT-r^2) - 2zr + \alpha_4 \tag{34}$$

$$2T\beta_7 = (2 + z)(tT - r^2) + 2zr + 2 - z \tag{35}$$

$$\alpha_3 = e^{2\gamma\ell}(2 - z) \tag{36}$$

$$\alpha_4 = e^{-\gamma\ell}(2 + z) \tag{37}$$

$$\beta_3 = \text{spur} ([Mn'] [Ml]^{-1}) \tag{38}$$

$$\beta_4 = \det ([Mn'][Ml]^{-1}) \tag{39}$$

$$\beta_5 = \text{spur} ([Mn'][Ml]^{-1}[Mz'][Ml]^{-1}) \tag{40}$$

$$\beta_6 = \text{spur} ([Mn'][Mz]^{-1}) \tag{41}$$

Nach kurzer Zwischenrechnung erhält man die gesuchten Größen des N-Netzwerkes.

$$r = \frac{\alpha_8}{2\alpha_7} \pm \sqrt{\left(\frac{\alpha_8}{2\alpha_7}\right)^2 - \frac{\alpha_9}{\alpha_7}} \tag{42}$$

$$T = \frac{\alpha_6}{\alpha_5} - 2\frac{z}{\alpha_5} r \tag{43}$$

$$t = T\beta_4 \tag{44}$$

$$\alpha_5 = e^{-\gamma\ell}(2 + z)\beta_3 - 2\beta_6 \tag{45}$$

$$\alpha_6 = e^{-2\gamma\ell}(2 + z) - 2 + z \tag{46}$$

$$\alpha_7 = \beta_4 \left(\frac{\alpha_6}{\alpha_5}\right)^2 \frac{2z}{\alpha_5}\beta_4 - 1 \tag{47}$$

$$\alpha_8 = 2\beta_4 \frac{\alpha_6}{\alpha_5} \frac{2z}{\alpha_5} - e^{-\gamma\ell} \frac{2z}{\alpha_5}\beta_3 \tag{48}$$

$$\alpha_9 = e^{-2\gamma\ell} - e^{-\gamma\ell}\beta_3 \frac{\alpha_6}{\alpha_5} \tag{49}$$

Demzufolge enthält das LZN-Verfahren im N-Standard drei unbekannte Größen, die zur Selbstkontrolle einer erfolgten Systemfehlerkalibrierung herangezogen werden können. Im Gegensatz zum LRM-Verfahren hat man hier zusätzlich Transmissionswerte als Selbstkalibriergrößen zur Verfügung.

Das LZZN-Verfahren

Die Tatsache, daß auch noch bei dem LZN-Verfahren der Serienwiderstand vollständig bekannt sein muß, kann mitunter zu Problemen führen. Abhilfe schafft bezüglich dieser Problematik das LZZN-Verfahren. Zur Durchführung dieses Verfahrens werden zwei unterschiedliche Serienwiderstände benötigt.
Von diesen beiden Widerständen soll nur noch jeweils der Realteil bekannt sein. Die Imaginärteile sind nunmehr die gesuchten Größen eines weiteren Selbstkalibrierschrittes. Stellt man Gleichung (22) für beide Widerstände auf und setzt unter Eliminierung von $e^{\gamma\ell}$ diese beiden Gleichungen gleich, so verfügt man über eine komplexe nichtlineare Gleichung zur Ermittlung der beiden Imaginärteile. Folglich läßt sich diese Gleichung nur noch numerisch auswerten.

Das LMS-Verfahren

Das LMS-Verfahren steht in sehr enger Verwandtschaft zu dem LRM-Verfahren. Diese beiden Verfahren unterscheiden sich dadurch, daß bei dem LMS-Verfahren die Leitung eine unbekannte Ausbreitungskonstante aufweisen darf und der Reflexionsstandard im Gegensatz zum LRM-Verfahren bekannt sein muß. Somit weist das LMS-Verfahren genauso wie auch das LRM-Verfahren nur eine unbekannte Selbstkalibriergröße auf. Die Ermittlung dieses unbekannten Transmissionswertes der Leitung kann unter anderem dadurch erfolgen, daß das homogene $8 * 8$ Gleichungssystem zur Ermittlung der Fehlerkoeffizienten bestehend aus den vier Gleichungen für den Leitungsstandard und den jeweils zwei Gleichungen für die Reflexionsstandards aufgestellt wird und daß das Gleichungssystem durch numerische Variation der Selbstkalibriergröße derart manipuliert wird, daß dessen Determinantenwert den für homogene Gleichungssysteme notwendigen Wert Null ergibt.
Danach können in herkömmlicher Art und Weise mit dem inhomogenen $7*7$ Gleichungssystem die 7 Fehlerterme bestimmt werden.

**Patentansprüche**

1.   Verfahren zum Kalibrieren eines zwei Meßtore (6, 7) und mindestens vier Meßstellen (8 bis 11) aufweisenden Netzwerk-Analysators durch aufeinanderfolgende Messung der Transmissions- und Reflexions-Parameter an drei nacheinander in beliebiger Reihenfolge zwischen die beiden Meßtore geschalteten Kalibrierstandards nach dem 7-Term-Prinzip, wobei eine erste Kalibriermessung an einer elektrischen Leitung (L) und eine zweite und dritte Kalibriermessung jeweils an einem zwischen die Meßtore geschalteten, aus konzentrierten Bauelementen (Y, Z) aufgebauten Zweitor durchgeführt wird und aus diesen Meßwerten Korrekturwerte berechnet werden, die bei nachfolgenden Objektmessungen berücksichtigt werden,
**dadurch gekennzeichnet,**

**daß** für die erste Kalibriermessung eine Leitung (L) verwendet wird, deren Wellenwiderstand bekannt ist und deren elektrische Ausbreitungskonstante ($\gamma$) unbekannt und komplex sein darf,
für die zweite Kalibriermessung ein Zweitor benutzt wird, das aus einem in Serie geschalteten Bauelement (Z) bekannter Impedanz und einem konzentrierten gegen Masse geschalteten Bauelement (Y) unbekannter Impedanz besteht,
und die dritte Kalibriermessung an diesem gleichen Zweitor der zweiten Kalibriermessung durchgeführt wird, das bezüglich der Anschlüsse an den beiden Meßtoren (6, 7) gedreht ist, wobei die elektrische Ausbreitungskonstante ($\gamma$) der Leitung der ersten Kalibriermessung aus den an allen drei Kalibrierstandards gemessenen Meßwerten anschließend berechnet wird.

**2.** Verfahren zum Kalibrieren eines zwei Meßtore (6, 7) und mindestens vier Meßstellen (8 bis 11) aufweisenden Netzwerk-Analysators durch aufeinanderfolgende Messung der Transmissions- und Reflexions-Parameter an drei nacheinander in beliebiger Reihenfolge zwischen die beiden Meßtore geschalteten Kalibrierstandards nach dem 7-Term-Prinzip, wobei eine erste Kalibriermessung an einer elektrischen Leitung (L) und eine zweite und dritte Kalibriermessung jeweils an einem zwischen die Meßtore geschalteten, aus konzentrierten Bauelementen (Y, Z) aufgebauten Zweitor durchgeführt wird und aus diesen Meßwerten Korrekturwerte berechnet werden, die bei nachfolgenden Objektmessungen berücksichtigt werden,
**dadurch gekennzeichnet,**

**daß** für die erste Kalibriermessung eine Leitung (L) verwendet wird, deren Wellenwiderstand bekannt ist und deren elektrische Ausbreitungskonstante ($\gamma$) unbekannt und komplex sein darf,
die zweite Kalibriermessung an einem Zweitor durchgeführt wird, das nur aus einem einzigen, die beiden Tore verbindenden, konzentrierten Bauelement (Z) bekannter Impedanz besteht
und die dritte Kalibriermessung an einem reflexionssymmetrischen Zweitor (N) durchgeführt wird, dessen Impedanz unbekannt sein darf, wobei die elektrische Ausbreitungskonstante ($\gamma$) der Leitung (L) der ersten Kalibriermessung aus den an allen drei Kalibrierstandards gemessenen Meßwerten anschließend berechnet wird.

**3.** Verfahren zum Kalibrieren eines zwei Meßtore (6, 7) und mindestens vier Meßstellen (8 bis 11) aufweisenden Netzwerk-Analysators durch aufeinanderfolgende Messung der Transmissions- und Reflexions-Parameter an drei nacheinander in beliebiger Reihenfolge zwischen die beiden Meßtore geschalteten Kalibrierstandards nach dem 7-Term-Prinzip, wobei eine erste Kalibriermessung an einer elektrischen Leitung (L) und eine zweite und dritte Kalibriermessung jeweils an einem zwischen die Meßtore geschalteten, aus konzentrierten Bauelementen (Y, Z) aufgebauten Zweitor durchgeführt wird und aus diesen Meßwerten Korrekturwerte berechnet werden, die bei nachfolgenden Objektmessungen berücksichtigt werden,
**dadurch gekennzeichnet,**

**daß** für die erste Kalibriermessung eine Leitung (L) verwendet wird, deren Wellenwiderstand bekannt ist und deren elektrische Ausbreitungskonstante ($\gamma$) unbekannt und komplex sein darf,
die zweite Kalibriermessung mit einem Eintor (M) durchgeführt wird, dessen Wellenwiderstand bekannt ist und das nacheinander an die beiden Meßtore angeschaltet wird, und
die dritte Kalibriermessung an einem weiteren Eintor (O oder S) durchgerührt wird, das bekannte Reflexion besitzt und nacheinander an die beiden Meßtore angeschaltet wird, wobei die elektrische Ausbreitungskonstante ($\gamma$) der Leitung (L) der ersten Kalibriermessung aus den an allen drei Kalibrierstandards gemessenen Meßwerten anschließend berechnet wird.

**4.** Verfahren nach einem der vorhergehenden Ansprüche,
**dadurch gekennzeichnet,**
**daß** die für die erste Kalibriermessung benutzte Leitung (L) in planarer Streifenleitungstechnik aufgebaut ist.

**Claims**

**1.** Method for calibrating, according to the 7-term principle, a network analyzer having two measuring ports (6, 7) and at least four measuring points (8 to 11) through successive measurement of the transmission and reflection parameters on three calibration standards connected successively in any sequence between the two measuring ports, a first calibration measurement being performed on an electrical line (L) and a second and third calibration measurement each being performed on a two-port, constructed from lumped components (Y, Z), connected between the measuring ports, and correction values, which are taken into account in subsequent object measurements, being calculated from these measured values,
**characterized in that**

used for the first calibration measurement is a line (L) whose characteristic impedance is known and whose electrical propagation constant ($\gamma$) may be unknown and complex,
used for the second calibration measurement is a two-port which consists of a serially connected component (Z) of known impedance and a lumped component (Y) of unknown impedance which is connected to earth, and the third calibration measurement is performed on this same two-port of the second calibration measurement which is rotated in respect of the connections to the two measuring ports (6, 7), the electrical propagation

constant ($\gamma$) of the line of the first calibration measurement being subsequently calculated from the values measured on all three calibration standards.

2. Method for calibrating, according to the 7-term principle, a network analyzer having two measuring ports (6, 7) and at least four measuring points (8 to 11) through successive measurement of the transmission and reflection parameters on three calibration standards connected successively in any sequence between the two measuring ports, a first calibration measurement being performed on an electrical line (L) and a second and third calibration measurement each being performed on a two-port, constructed from lumped components (Y, Z), connected between the measuring ports, and correction values, which are taken into account in subsequent object measurements, being calculated from these measured values,
**characterized in that**

used for the first calibration measurement is a line (L) whose characteristic impedance is known and whose electrical propagation constant ($\gamma$) may be unknown and complex,
the second calibration measurement is performed on a two-port which consists only of a single lumped component (Z) of known impedance which connects the two ports,
and the third calibration measurement is performed on a symmetrical-reflection two-port (N) whose impedance may be unknown, the electrical propagation constant ($\gamma$) of the line (L) of the first calibration measurement being subsequently calculated from the values measured on all three calibration standards.

3. Method for calibrating, according to the 7-term principle, a network analyzer having two measuring ports (6, 7) and at least four measuring points (8 to 11) through successive measurement of the transmission and reflection parameters on three calibration standards connected successively in any sequence between the two measuring ports, a first calibration measurement being performed on an electrical line (L) and a second and third calibration measurement each being performed on a two-port, constructed from lumped components (Y, Z), connected between the measuring ports, and correction values, which are taken into account in subsequent object measurements, being calculated from these measured values,
**characterized in that**

used for the first calibration measurement is a line (L) whose characteristic impedance is known and whose electrical propagation constant ($\gamma$) may be unknown and complex,
the second calibration measurement is performed with a one-port (M) whose characteristic impedance is known and which is connected successively to the two measuring ports,
and the third calibration measurement is performed on a further one-port (O or S) which has known reflection and is connected successively to the two measuring ports, the electrical propagation constant ($\gamma$) of the line (L) of the first calibration measurement being subsequently calculated from the values measured on all three calibration standards.

4. Method according to any one of the preceding Claims,
**characterized in that**
the line (L) used for the first calibration measurement is of a planar strip line construction.

**Revendications**

1. Procédé pour étalonner un analyseur de réseau comportant deux portes de mesure (6,7) et au moins quatre points de mesure (8 à 11), au moyen de la mesure successive des paramètres de transmission et de réflexion au niveau de trois étalons montés selon une succession quelconque entre les deux portes de mesure, selon le principe des 7 termes, selon lequel une première mesure d'étalonnage est effectuée dans une ligne électrique (L) et des seconde et troisième mesures d'étalonnage sont exécutées respectivement au niveau d'une porte double montée entre les portes de mesure et constituée par des composants concentrés (Y,Z), et des valeurs de correction, qui sont prises en compte lors de mesures ultérieures d'un objet, sont calculées à partir de ces valeurs de mesure,
**caractérisé en ce**

**que** pour la première mesure d'étalonnage, on utilise une ligne (L), dont l'impédance caractéristique est connue et dont la constante de propagation électrique ($\gamma$) peut être inconnue et complexe,
**que** pour la seconde mesure d'étalonnage on utilise une porte double, qui est constituée par un composant (Z) d'impédance connue, branché en série, et par un composant concentré (Y) d'impédance inconnue, connecté à la masse, et

la troisième mesure d'étalonnage est exécutée au niveau de cette même porte double utilisée pour la seconde mesure d'étalonnage et qui est pivotée par rapport aux bornes de raccordement aux deux portes de mesure (6,7), la constante de propagation électrique ($\gamma$) de la ligne pour la première mesure d'étalonnage étant calculée ensuite à partir des valeurs de mesure mesurées sur l'ensemble des trois étalons.

2. Procédé pour étalonner un analyseur de réseau comportant deux portes de mesure (6,7) et au moins quatre points de mesure (8 à 11), au moyen de la mesure successive des paramètres de transmission et de réflexion au niveau de trois étalons montés selon une succession quelconque entre les deux portes de mesure, selon le principe des 7 termes, selon lequel une première mesure d'étalonnage est effectuée dans une ligne électrique (L) et des seconde et troisième mesures d'étalonnage sont exécutées respectivement au niveau d'une porte double montée entre les portes de mesure et constituée par des composants concentrés (Y,Z), et des valeurs de correction, qui sont prises en compte lors de mesures ultérieures d'un objet, sont calculées à partir de ces valeurs de mesure, **caractérisé en ce**

que pour la première mesure d'étalonnage, on utilise une ligne (L), dont l'impédance caractéristique est connue et dont la constante de propagation électrique ($\gamma$) peut être inconnue et complexe,
que la seconde mesure d'étalonnage est exécutée au niveau d'une porte double, qui est constituée par un seul composant concentré (Z), qui relie les deux portes et possède une impédance connue, et
que la troisième mesure d'étalonnage est exécutée au niveau d'une porte double (N) symétrique en réflexion, dont l'impédance peut être inconnue, la constante de propagation électrique ($\gamma$) de la ligne (L) pour la première mesure d'étalonnage étant calculée ensuite à partir des valeurs de mesure mesurées sur l'ensemble des trois étalons.

3. Procédé pour étalonner un analyseur de réseau comportant deux portes de mesure (6,7) et au moins quatre points de mesure (8 à 11), au moyen de la mesure successive des paramètres de transmission et de réflexion au niveau de trois étalons montés selon une succession quelconque entre les deux portes de mesure, selon le principe des 7 termes, selon lequel une première mesure d'étalonnage est effectuée dans une ligne électrique (L) et des seconde et troisième mesures d'étalonnage sont exécutées respectivement au niveau d'une porte double montée entre les portes de mesure et constituée par des composants concentrés (Y,Z), et des valeurs de correction, qui sont prises en compte lors de mesures ultérieures d'un objet, sont calculées à partir de ces valeurs de mesure, **caractérisé en ce**

que pour la première mesure d'étalonnage, on utilise une ligne (L), dont l'impédance caractéristique est connue et dont la constante de propagation électrique ($\gamma$) peut être inconnue et complexe,
que la seconde mesure d'étalonnage est exécutée avec une porte simple (M), dont l'impédance caractéristique est connue et qui est connectée successivent aux deux portes de mesure, et
que la troisième mesure d'étalonnage est exécutée au niveau d'une autre porte simple (O ou S), qui possède une réflexion connue et est connectée successivement aux deux portes de mesure, la constante de propagation électrique ($\gamma$) de la ligne (L) pour la première mesure d'étalonnage étant calculée ensuite à partir des valeurs de mesure mesurées sur l'ensemble des trois étalons.

4. Procédé selon l'une des revendications précédentes, **caractérisé en ce**

que la ligne (L) utilisée pour la première mesure d'étalonnage est agencée selon la technique planar des lignes en forme de rubans.

Fig. 1:

$$[S] = \begin{bmatrix} S_{11} & S_{12} \\ S_{21} & S_{22} \end{bmatrix}$$

Fig. 2:

Fig. 3: